# EUROPEAN PATENT APPLICATION

(11) **EP 4 362 072 A1**
(43) Date of publication of application: **01.05.2024**
(21) Application number: 22827641.6
(22) Date of filing: 23.06.2022
(51) Int. Cl.: H01L 21/67

(54) **SEMICONDUCTOR PROCESS DEVICE, AND CONTROL METHOD AND APPARATUS FOR MOVING COMPONENT THEREOF**

(30) Priority: 25.06.2021 CN 202110707154
(71) Applicant: Beijing NAURA Microelectronics Equipment Co., Ltd., Beijing 100176 (CN)
(72) Inventor: ZHU, Jinheng, Beijing 100176 (CN)
(74) Representative: Cohausz & Florack
(86) International application number: PCT/CN2022/100658
(87) International publication number: WO 2022/268149

(57) **Abstract**

The present disclosure provides a control method and a control apparatus for controlling moving parts in a semiconductor process device. The control method includes: obtaining a current process task, the process task including a plurality of sub-task objects; determining a current sub-task object and sub-task objects that need to be executed from the plurality of sub-task objects, the sub-task objects that need to be executed are configured to be executed after the current sub-task object is executed; controlling a current moving part associated with the current sub-task object to execute the current sub-task object; after the execution of the current sub-task object is completed, determining standby moving parts associated with the sub-task objects that need to be executed; and in response to the standby moving parts not including the current moving part, setting a movement state of the current moving part to ready. The utilization of the moving parts is improved. The execution time of the corresponding sub-task objects is shortened. The total execution time of the process tasks is shortened. The process device productivity is improved.

## Description

### TECHNICAL FIELD

The present disclosure relates to the technical field of semiconductor process technology, and more particularly, to a semiconductor process device, a method and apparatus for moving parts thereof.

### BACKGROUND

In a semiconductor process device (such as wafer cleaning device), an upper computer mainly includes a coordination module (i.e., a coordinator) and a scheduling module (i.e., a scheduler). The scheduling module is used to calculate an optimized execution sequence of process tasks (i.e., jobs) based on process device information input by the coordination module to ensure process device productivity. The coordination module is used to interact with the scheduling module, receive a process task sequence outputted from the scheduling module, and control a lower computer (such as a transport control module and/or a process control module, etc.) to complete corresponding process tasks. One of the core functions of the control software in the upper computer is controlling process tasks. During the execution of the process tasks, the coordination module may continuously receive the process task sequence outputted from the scheduling module and assign the process tasks in the process task sequence to corresponding moving parts (such as a robot arm or a slot cover) to perform the process tasks.

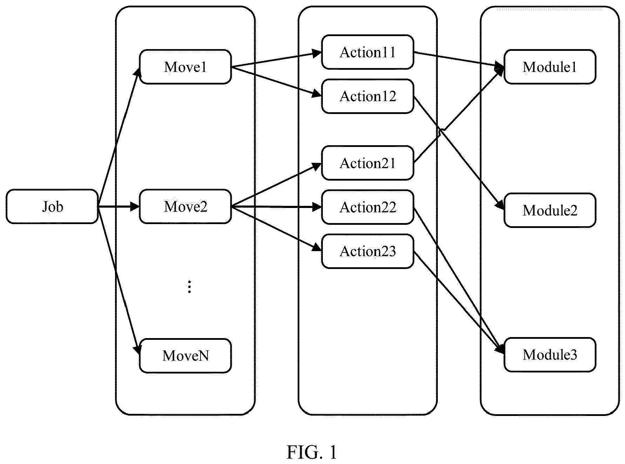

Specifically, as shown in FIG. 1, the process tasks output by the scheduling module include multiple a plurality of process tasks (e.g., moves): Move1, Move2, ..., MoveN in FIG. 1. Each process task includes at least one sub-task object (e.g., an action) with a pre-determined execution sequence. As shown in FIG. 1, Move1 includes Action11 and Action12, and Move2 includes Action21, Action22 and Action23. For each sub-task object, the coordination module may send a name and a parameter of a specific process task to be executed to a corresponding moving part (e.g., a module). Each sub-task object is executed by the corresponding moving part. As shown in FIG. 1, Action11 in Move1 is executed by Module 1, Action12 is executed by Module2, Action21 in Move2 is executed by Module1, and Action22 and Action23 are both executed by Module3. Before each process task starts to be executed, the coordination module may set the moving parts involved in all the sub-task objects contained in the process task to occupied. Until all the sub-task objects included in the process task have been executed, the relevant moving parts will not be released. The moving parts may continuously scan whether any sub-task object needs to be executed, but will only execute the sub-task objects in the process task that it is set to occupied. This design can ensure to a certain extent that the relevant moving parts will not execute the sub-task objects of other process tasks before all sub-task objects of the previous process task are completely executed, avoiding interference between the sub-task objects of various process tasks. However, during the execution of the process tasks, occupied settings of the moving parts are too absolute, which can easily lead to underutilization of the moving parts, and may affect the corresponding process device productivity.

### SUMMARY

In view of this, the present disclosure provides a control method and control apparatus for controlling a semiconductor process device and its moving parts to solve the problem of low utilization of moving parts in traditional solutions. The low utilization may affect process device productivity.

One aspect of the present disclosure provides a control method for controlling moving parts in a semiconductor process device. The semiconductor process device includes a plurality of moving parts. The control method includes: obtaining a current process task, the process task including a plurality of sub-task objects; determining a current sub-task object and sub-task objects that need to be executed from the plurality of sub-task objects, the sub-task objects that need to be executed are configured to be executed after the current sub-task object is executed; controlling a current moving part associated with the current sub-task object to execute the current sub-task object; after the execution of the current sub-task object is completed, determining standby moving parts associated with the sub-task objects that need to be executed; and in response to the standby moving parts not including the current moving part, setting a movement state of the current moving part to ready.

Optionally, before obtaining the current process task, the control method further includes: receiving a plurality of process tasks and determining a first received process task to be the current process task; identifying moving parts associated with each sub-task object in the current process task; and setting the movement states of the moving parts associated with each sub-task object to occupied.

Optionally, after determining the standby moving parts associated with the sub-task objects that need to be executed, the control method further includes: in response to the standby moving parts including the current moving part, maintaining the movement state of the current moving part as occupied.

Optionally, after setting the movement state of the current moving part to ready or maintaining the movement state of the current moving part as occupied, the control method further includes: controlling the standby moving parts to sequentially execute the sub-task objects that need to be executed; and after all sub-task objects in the current process task are executed, setting the movement state of each associated moving part to ready.

Optionally, after setting the movement state of the current moving part to ready, the control method further includes: determining whether process tasks to be executed after the current process task include the sub-task object associated with the current moving part; and in response to the process tasks to be executed after the current process task including the sub-task object associated with the current moving part, controlling the current moving part to execute in advance the sub-task object associated with the current moving part.

Another aspect of the present disclosure provides a control apparatus for controlling moving parts in a semiconductor process device. The semiconductor process device includes a plurality of moving parts. The control apparatus includes: an acquisition unit configured to obtain a current process task, the process task including a plurality of sub-task objects; a first determination unit configured to determine a current sub-task object and sub-task objects that need to be executed from the plurality of sub-task objects, the sub-task object that need to be executed being configured to be executed after the current sub-task object is executed; a first control unit configured to control a current moving part associated with the current sub-task object to execute the current sub-task object; a second determination unit configured to determine standby moving parts associated with the sub-task objects that need to be executed after the current sub-task object is executed; and a first setting unit configured to set a movement state of the current moving part to ready when the standby moving parts do not include the current moving part.

Optionally, the control apparatus further includes: a receiving unit configured to receive a plurality of process tasks, and determine a process task received first as the current process task; an identification unit configured to identify the moving parts associated with each sub-task object in the current process task; and a second setting unit configured to set the movement states of the moving parts associated with each sub-task object to occupied.

Optionally, the first setting unit is further configured to: in response to the standby moving parts including the current moving part, maintain the movement state of the current moving part as occupied.

Optionally, the control apparatus further includes: a second control unit configured to control the standby moving parts to sequentially execute the sub-task objects that need to be executed; and a third setting unit configured to set the movement state of each associated moving part to ready after all sub-task objects of the current process task are executed.

Optionally, the control apparatus further includes: a third determination unit configured to determine whether the process task to be executed after the current process task includes a sub-task object associated with the current moving part; and a third control unit configured to control the current moving part to execute the sub-task object in advance when the process task to be executed after the current process task includes a sub-task object associated with the current moving part.

Another aspect of the present disclosure provides a semiconductor process device. The semiconductor process device includes the disclosed control apparatus for controlling the plurality of moving parts in the semiconductor process device.

The control method and control apparatus control the moving parts in the semiconductor process device by obtaining the current process task, determining the current sub-task object and the sub-task objects that need to be executed from the plurality of sub-task objects, and controlling the current moving part to execute the current sub-task object. After the current sub-task object is executed, the standby moving parts associated with the sub-task objects that need to be executed are determined. When the standby moving parts do not include the current moving part, the movement state of the current moving part is set to ready, such that the current moving part can be released in advance. The current moving part can be called by other process tasks without waiting for all sub-task objects included in the process task to be executed, providing the possibility for other process tasks to be executed in advance. Further, a mechanism for executing the sub-task objects subsequently associated with the current moving part in advance is added to further improve the utilization of the moving parts and the execution continuity between the moving parts. thus, the execution time of the corresponding sub-task objects is shortened, the total execution time of the process tasks is shortened, and the process device productivity is improved.

### BRIEF DESCRIPTION OF THE DRAWINGS

To more clearly illustrate the technical solution of the present disclosure, the accompanying drawings used in the description of the disclosed embodiments are briefly described below. The drawings described below are merely some embodiments of the present disclosure. Other drawings may be derived from such drawings by a person with ordinary skill in the art without creative efforts and may be encompassed in the present disclosure.
FIG. 1 is a schematic diagram showing relationship between process tasks and moving parts in a semiconductor process device according to some embodiments of the present disclosure;
FIG. 2 is a flowchart of an existing process of controlling moving parts;
FIG. 3 is a flowchart of an exemplary process of controlling moving parts in a semiconductor process device according to some embodiments of the present disclosure;
FIG. 4 is a flowchart of another exemplary process of controlling moving parts in a semiconductor process device according to some embodiments of the present disclosure;
FIG. 5 is a flowchart of an exemplary process of setting a movement state of a moving part associated with a current process task according to some embodiments of the present disclosure;
FIG. 6 is a flowchart of an exemplary process of executing a certain sub-task object according to some embodiments of the present disclosure;
FIG. 7 is a schematic structural diagram of an exemplary control apparatus controlling moving parts in a semiconductor process device according to some embodiments of the present disclosure; and
FIG. 8 is a schematic structural diagram of an exemplary semiconductor process device according to some embodiments of the present disclosure.

### DETAILED DESCRIPTION OF THE EMBODIMENTS

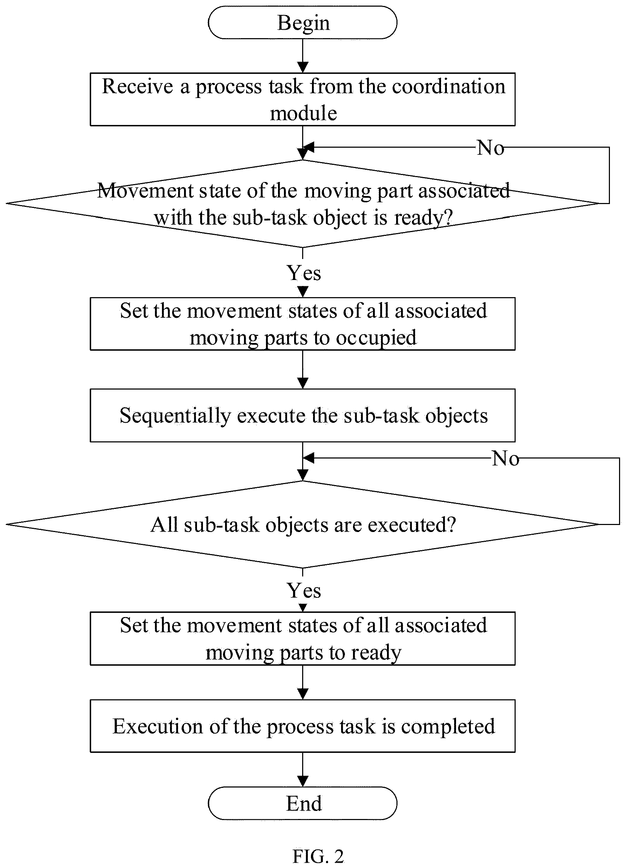

The process task execution process described in the background section may be referred to as shown in FIG. 2. The coordination module receives a process task from the scheduling module, identifies whether moving parts associated with each sub-task object in the process task are in a ready state, when all the associated moving parts are in the ready state, sets all the moving parts to an occupied state, and executes each sub-task object sequentially. After all the sub-task objects are executed, the associated moving parts are set to the ready state. At this time, the current process task is completed. The status of each process task outputted by the scheduling module will be analyzed below with reference to FIG. 1. Task Move1 occupies moving parts Module1 and Module2. Task Move2 occupies moving parts Module1 and Module3. After finishing executing a sub-task Action11, Module1 will be in a no-action state (i.e., ready state). However, since Module1 itself is occupied by Move1, it will not be released until all sub-task objects included in Move1 are executed. As a result, Move2 is in an idle state. Move2 will not start until all sub-task objects of Move1 have been executed. It can be seen that during the execution of traditional process tasks, the occupied status setting mechanism of moving parts is too absolute, resulting in low utilization of moving parts and likely degrading process device productivity. Specifically, a moving part that only performs one sub-task at the beginning of the process task (subsequent sub-tasks of other moving parts will not interfere with the sub-task of this moving part) will remain in the idle state for a long time and perform no other sub-tasks after executing the sub-task assigned by the current process task.

In view of the problems occurred in the task execution mechanism of moving parts in an existing semiconductor process device, the present disclosure provides a control method and apparatus for a semiconductor process device and its moving parts. The control method includes a new monitoring mechanism for execution completion timing of sub-task objects. After a current moving part executes a current sub-task object, a relationship between to-be-used moving parts and the current moving part is determined. If the to-be-used moving parts do not include the current moving part, a movement state of the current moving part is set to ready, such that there is an opportunity to update the movement state of the current moving part before the current process task is completed, and it is possible to release the current moving parts in advance. Thus, the utilization of the moving parts that are released in advance can be improved, thereby increasing the process device productivity.

The technical solutions in the embodiments of the present disclosure will be clearly and completely described below with reference to the accompanying drawings. Obviously, the described embodiments are only some of the embodiments of the present disclosure, not all of them. Based on the embodiments in the present disclosure, all other embodiments obtained by those skilled in the art without creative efforts shall fall within the scope of protection of the present disclosure. The following embodiments and their technical features may be combined with each other in absence of conflict.

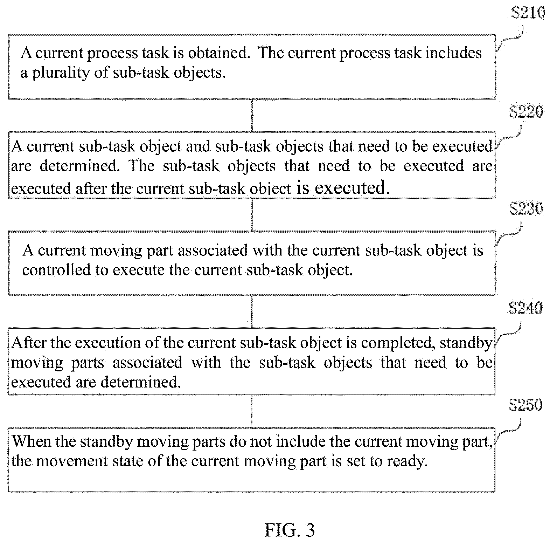

The present disclosure provides a method for controlling moving parts in a semiconductor process device. The semiconductor process device includes a plurality of moving parts. As shown in FIG. 3, the control method includes the following processes.

At S210, a current process task is obtained. The current process task includes a plurality of sub-task objects.

At S220, a current sub-task object and sub-task objects that need to be executed are determined from the plurality of sub-task objects. The sub-task objects that need to be executed are configured to be executed after the current sub-task object is executed.

At S230, a current moving part associated with the current sub-task object is controlled to execute the current sub-task object.

At S240, after the execution of the current sub-task object is completed, standby moving parts associated with the sub-task objects that need to be executed are determined.

At S250, when the standby moving parts do not include the current moving part, the movement state of the current moving part is set to ready.

The scheduling module of the semiconductor process device sets processes of each process task in the programming stage, such that each process task includes at least one sub-task object, and at least one sub-task object is executed sequentially. The coordination module obtains the process task that needs to be executed, identifies each sub-task object included in the process task, and sequentially controls the corresponding moving parts to execute each sub-task object in the order of execution. When executing a certain sub-task object, the moving part will continuously feedback its movement state (such as ready or occupied) to the coordination module, such that the coordination module can monitor the execution completion timing of all sub-task objects in the process task.

Specifically, the coordination module obtains the current process task and controls each moving part to execute the corresponding sub-task object. The sub-task object currently being executed is the current sub-task object, and the sub-task objects whose execution order is after the current sub-task object are the sub-task objects that needs to be executed. To execute a sub-task object, the moving part associated with the current sub-task object is the current moving part, and the moving parts associated with the sub-task objects that need to be executed are the standby moving parts. The current moving part includes each moving part that executes and assists in executing the current sub-task object, and the standby moving parts include each moving part that executes and assists in executing each sub-task object that needs to be executed.

In some embodiments, after the current moving part executes the current sub-task object, the standby moving parts associated with the sub-task objects that need to be executed are determined. When the standby moving parts do not include the current moving part, the movement state of the current moving part is set to ready to update the movement state of the current moving part before the current process task is completed, such that the current moving part has the opportunity to update its movement state before the current process task is completed. Thus, it becomes possible for the current moving part to be released early, and the utilization of the moving part that is released early can be improved.

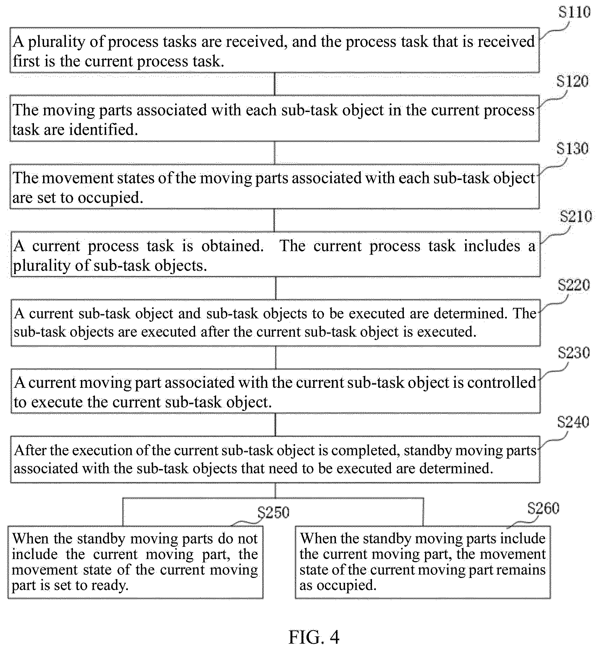

In some embodiments, the control method of controlling the moving parts in a semiconductor process device is illustrated in FIG. 4. Before obtaining the current process task, the control method may also include the following processes.

At S110, a plurality of process tasks are received, and the process task that is received first is the current process task.

At S120, the moving parts associated with each sub-task object in the current process task are identified.

At S130, the movement states of the moving parts associated with each sub-task object are set to occupied.

After the plurality of process tasks are received, the control method uses the first received process task as the current process task, identifies the moving parts associated with each sub-task object in the current process task, and sets the movement states of each identified moving part to occupied. After being set to occupied, the corresponding moving parts are controlled to sequentially execute each sub-task object in accordance with the order of execution, such that the current process task can be executed in a timely manner, that is, the first received process task is executed in a timely manner. Thus, the execution order of each process task can be properly maintained.

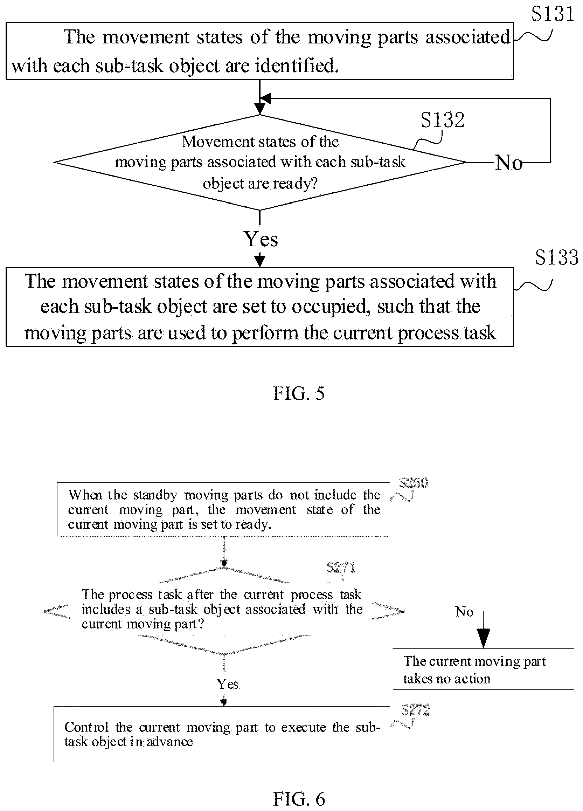

Specifically, as shown in FIG. 5, at S130, setting the movement states of the moving parts associated with each sub-task object to occupied may include the following processes.

At S131, the movement states of the moving parts associated with each sub-task object are identified.

At S132, whether the movement states of the moving parts associated with each sub-task object are ready is determined. If so, S133 is performed. If not, S 132 is executed again until it is detected that each and every associated moving part is ready, such that each moving part associated with each sub-task object is used to execute the current process task after being released by other process tasks, ensuring that the other process tasks are properly executed.

At S133, the movement states of the moving parts associated with each sub-task object are set to occupied, such that the moving parts are used to perform the current process task.

In some other embodiments, the coordination module of the semiconductor process device may also set the movement states of the current action task according to other rules. For example, if the plurality of received process tasks carry priority flags, the process task with a highest priority among them can be set as the current process task, and so on.

Further, as shown in FIG. 4, after determining the standby moving parts associated with the sub-task objects that need to be executed, the control method may further include the following process.

At S260, when the standby moving parts include the current moving part, the movement state of the current moving part remains occupied.

When the standby moving parts include the current moving part, the movement state of the current moving part remains as occupied, such that the current moving part can continue to be used to execute the corresponding sub-task object in the current process task to ensure that the current process task is executed smoothly.

In one example, after setting the movement state of the current moving part to ready or maintaining the movement state of the current moving part as occupied, the control method further includes: controlling the standby moving parts to sequentially execute the sub-task objects that need to be executed, and after all sub-task objects of the current process task are executed, setting the movement state of each associated moving part to ready.

In this example, after all sub-task objects of the current process task are executed, the movement state of each associated moving part is set to ready, such that the moving parts can be used by other process tasks, thereby ensuring the desired utilization of these moving parts.

In some embodiments, as shown in FIG. 6, after setting the movement state of the current moving part to ready, the control method further includes the following processes.

At S271, whether the process task after the current process task includes a sub-task object associated with the current moving part is determined. If so, S272 is executed. If not, no action is performed by the current moving part.

At S272, the current moving part is controlled to execute the sub-task object in advance.

In some embodiments, the sub-task object associated with the current moving part may be called a special sub-task object. The special sub-task object may include one or more sub-tasks that need to be executed with priority. The priority of execution refers to that after the movement state of the current moving part is set to ready, even if the current moving part is set to occupied by other process tasks, the special sub-task object will be executed first before any sub-task objects corresponding to the other process tasks are executed. In other words, the special sub-task object can be regarded as a previous sub-task or sub-tasks of the other process tasks.

Specifically, after the movement state of a certain moving part is set to ready, the moving part is controlled to first execute a special sub-task object. When a next sub-task of the moving part is determined according to the relevant business process, the next sub-task for the moving part has already been executed in advance. In some cases, when the next sub-task associated with the moving part is started, only the special sub-task objects that need to be executed in advance are detected to save the corresponding execution time. In some other cases, although the special sub-task object that has already been executed still needs to be executed, needs to be executed has been executed by the component in advance, once the moving part is in the state of completing the execution of the special sub-task object, the relevant task service program will return immediately and will not repeatedly execute the special sub-task object. thus, time consumption of task execution is reduced.

For example, a transport part that executes transport of the sub-task objects. After the transport part completes the transport of the sub-task objects in the current process task, the movement state of the transport part is set to ready. When the transport part executes the transport of the sub-task objects in other subsequent process tasks, a homing task needs to be performed first. The homing task is a special sub-task object corresponding to the transport part. After the coordination module sets the movement state of the transport part to ready, the coordination module controls the transport part to perform the homing task in advance. If the transport part performs subsequent transport sub-task objects of other process tasks, the coordination module may only need to detect the execution of the homing task. This can save the execution time of the homing task. If the coordination module also needs to control the transport part to perform the homing task, because the transport part is already in the state of completing the homing task, the task service program will return immediately. At this time, the execution time consumption corresponding to the homing task can still be reduced.

In one example, the control method of controlling moving parts in the semiconductor process device is illustrated by a process of taking a wafer from a wafer box (e.g., Foup box) in a certain semiconductor cleaning device (e.g., 300mm cassette-less). The process of taking the wafer from the wafer box includes two process tasks as shown in Table 1: a wafer pick-and-place task (WHRTransferMove) and a wafer box transfer task (FTRFoupMove). The wafer pick-and-place task includes opening the wafer box (OpenerLoad), taking out the wafer from the wafer box (PickWaferFromOpener), and sending the wafer to a central transport unit (PlaceWaferToCTU). The wafer box transfer task includes closing the wafer box (OpenerUnload), taking out the wafer box (PickFoupFromOpener) from a wafer box opener, and sending the wafer box to a wafer box staging shelf (PlaceFoupToShelf). The moving parts associated with the wafer pick-and-place task include a wafer box opener (Opener), a wafer pick-and-place robot arm (WHR), and a central transport unit (CTU). The specific execution process includes the following. The wafer box opener opens the wafer box. The wafer pick-and-place robot arm takes out the wafer from the opened wafer box. The wafer pick-and-place robot arm sends the taken-out wafer to the central transport unit. As such, opening the wafer box is associated with the wafer box opener, taking out the wafer from the wafer box is associated with the wafer box opener and the wafer pick-and-place robot arm, and sending the wafer to the central transport unit is associated with the wafer pick-and-place robot arm and the central transport unit. The moving parts associated with the wafer box transfer task include the wafer box opener, a wafer box transfer robot arm (FTR), and the wafer box staging shelf (Shelf). The specific execution process includes the following. The wafer box opener closes the wafer box. The wafer box transfer robot arm takes the wafer box from the wafer box opener and transfers the wafer box to the wafer box staging shelf. As such, closing the wafer box is associated with the wafer box opener, taking the wafer box from the wafer box opener is associated with the wafer box opener and wafer box transfer robot arm, and transferring the wafer box to the wafer box staging shelf is associated with the wafer box transfer robot arm and the wafer box staging shelf. Closing the wafer box is a sub-task object (special sub-task object) associated with other process tasks after the movement state of the wafer box opener is set to ready.

**Table 1**

| Process task | Sub-task object | Moving parts |
|---|---|---|
| Wafer pick-and-place task | 1. opening the wafer box; | 1. the wafer box opener: opening the wafer box; |
| | 2. taking the wafer from the wafer box; | 2. the wafer pick-and-place robot arm: taking the wafer from the opened wafer box; |
| | 3. sending the wafer to the | 3. CTU: exchange the wafer |
| | central transport unit (CTU). | from the wafer pick-and-place robot arm. |
| Wafer box transfer task | 1. closing the wafer box; | 1. the wafer box opener: closing the wafer box; |
| | 2. taking the wafer box from the wafer box opener; | 2. the wafer transfer robot arm: taking wafer box from the wafer box opener and transferring the wafer box to the wafer box staging shelf; |
| | 3. transferring the wafer box to the wafer box staging shelf. | 3. wafer box staging shelf: staging the wafer box. |

As shown in Table 1, the wafer is taken out from the wafer box, which is performed in the wafer pick-and-place task. After the wafer is taken out, the empty wafer box is transferred to the wafer box staging shelf and stored. The wafer box opener is vacated to continue to be used for incoming and outgoing of subsequent wafers, which is performed in the wafer box transfer task. During the execution of the wafer pick-and-place task, after the wafer is taken out from the wafer box, its associated wafer box opener is no longer associated with subsequent wafer transfer to the central transport unit. The movement state of the wafer box opener can be set to ready and can be released in advance, making it possible to start and execute the wafer box transfer task in advance.

When the wafer box transfer task needs to be executed, the wafer box transfer robot arm may be busy with other process tasks at this time. During the execution of the wafer pick-and-place task, the wafer box transfer robot arm may continue to execute closing the wafer box as a special sub-task object after the wafer box opener is released. When both the wafer box opener and the wafer box staging shelf are ready, and the wafer box transfer task has a condition for starting the execution, the sub-task objects will be executed according to a pre-determined execution sequence. Under certain circumstance, closing the wafer box may be executed first. However, closing the wafer box has been completed in advance. Thus, the lower computer service will return immediately, which can still reduce the execution time consumption of closing the wafer box.

The control method of controlling the moving parts in the semiconductor process device aims at the problems existed in the task execution mechanism of the moving parts in the existing semiconductor process device, improves the control process of sub-task objects, adds a mechanism to release the moving parts in advance and a mechanism to execute in advance sub-task objects that the moving part needs to execute in responding to subsequent process tasks. Thus, the utilization of the moving parts is improved, the sub-task objects are executed seamlessly from one moving part to another moving part, the execution time of corresponding sub-task objects is shortened, the overall execution time of the process tasks is shortened, and the productivity of the semiconductor process device is improved.

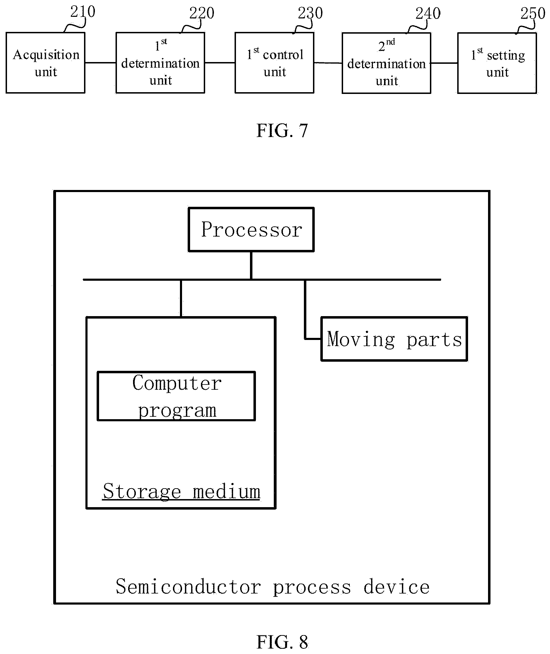

The present disclosure also provides a control apparatus device for controlling moving parts in the semiconductor process device. The semiconductor process device includes a plurality of moving parts. As shown in FIG. 7, the control apparatus includes: an acquisition unit 210, a first determination unit 220, a first control unit 230, a second determination unit 240, and a first setting unit 250.

The acquisition unit 210 is used to obtain a current process task. The current process task includes a plurality of sub-task objects. The first determination unit 220 is used to determine a current sub-task object and sub-task objects that need to be executed from the plurality of sub-task objects, and the sub-task object that need to be executed are configured to be executed after the current sub-task object is executed. The first control unit 230 is used to control a current moving part associated with the current sub-task object to execute the current sub-task object. The second determination unit 240 is used to determine standby moving parts associated with the sub-task objects that need to be executed after the current sub-task object is executed. The first setting unit 250 is used to set a movement state of the current moving part to ready when the standby moving parts do not include the current moving part.

In some embodiments, the control apparatus further includes: a receiving unit, an identification unit, and a second setting unit. The receiving unit is used to receive a plurality of process tasks, and determine a process task received first as the current process task. The identification unit is used to identify the moving parts associated with each sub-task object in the current process task. The second setting unit is used to set the movement states of the moving parts associated with each sub-task object to occupied.

Specifically, the first setting unit is also used to maintain the movement state of the current moving part as occupied when the standby moving parts include the current moving part,

Specifically, the control apparatus also includes: a second control unit and a third setting unit. The second control unit is used to control the standby moving parts to sequentially execute the sub-task objects that need to be executed. The third setting unit is used to set the movement state of each associated moving part to ready after all sub-task objects of the current process task are executed.

In some embodiments, the control apparatus further includes: a third determination unit and a third control unit. The third determination unit is used to determine whether the process task to be executed after the current process task includes a sub-task object associated with the current moving part. The third control unit is used to control the current moving part to execute the sub-task object in advance when the process task to be executed after the current process task includes a sub-task object associated with the current moving part.

For specific limitations on the control apparatus for controlling the moving parts in the semiconductor process device, reference can be made to the above limitations on the control method for controlling the moving parts in the semiconductor process device, which will not be described again herein. Each unit in the control apparatus for controlling the moving part in the semiconductor process device can be implemented in whole or in part by software, hardware, and combinations thereof. Each of the above units may be embedded in or independent of a processor of a computer device in the form of hardware, or may be stored in a memory of the computer device in the form of software, such that the processor can call and execute operations corresponding to each of the above units.

The present disclosure also provides a semiconductor process device. The semiconductor process device includes a control apparatus for controlling moving parts in the semiconductor process device as described in any of the above embodiments. The semiconductor process device has all the beneficial effects of the disclosed control apparatus, and the productivity of the semiconductor process device is effectively improved.

The present disclosure also provides a semiconductor process device. As shown in FIG. 8, the semiconductor process device includes a processor, a storage medium, and a plurality of moving parts. The storage medium stores program codes. The processor is configured to call the program codes stored in the storage medium to perform the control method for controlling moving parts in the semiconductor process device as described in any of the above embodiments.

When the semiconductor process device executes the control method for controlling the moving parts in the semiconductor process device, a mechanism for releasing the moving parts in advance and a mechanism for early execution of the sub-task objects subsequently associated with the moving parts are set up to improve the utilization of the moving parts, and to improve continuity of executing the process tasks between the moving parts. Thus, the execution time of corresponding sub-task objects is shortened, the total execution time of process tasks is shortened, and the productivity of the semiconductor process device is improved.

Although the present disclosure has been shown and described with respect to one or more embodiments, equivalent variations and modifications will occur to those skilled in the art based on a reading and understanding of the specification and the accompanying drawings. The present disclosure includes all such modifications and variations and is limited only by the scope of the appended claims. Specifically, with respect to the various functions performed by the above-described units or parts, the terms used to describe such units or parts are intended to correspond to any unit or part (unless otherwise indicated) that performs the specified function of the recited unit or part (e.g., functionally equivalent), even if not structurally equivalent to the disclosed structure that performs the functions in the embodiments of this specification shown herein.

That is, the above descriptions are only exemplary embodiments of the present disclosure, and do not limit the scope of the present disclosure. Any equivalent structure or equivalent process variation made using the contents of the description and drawings of the present disclosure, such as the technical feature combination with each other between the various embodiments, or direct or indirect application in other related technical fields, are all equally included in the scope of protection of the present disclosure.

In addition, the terms "first" and "second" are used for descriptive purposes only and cannot be construed as indicating or implying relative importance or implicitly indicating the quantity of indicated technical features. Therefore, the features defined as "first" and "second" may explicitly or implicitly include one or more features. In the description of the present disclosure, "plurality" refers to two or more, unless otherwise explicitly and specifically defined.

In the present disclosure, the word "exemplary" is used to refer to "serving as an example, illustration, or illustration." Any embodiment described herein as "exemplary" is not necessarily to be construed as preferred or advantageous over other embodiments. The above description is presented to enable any person skilled in the art to make and use the present disclosure. In the above description, various details are set forth for the purpose of illustration. It should be understood that one of ordinary skill in the art will recognize that the present disclosure may be practiced without these specific details. In other embodiments, well-known structures and processes have not been described in detail to avoid obscuring the description of the present disclosure with unnecessary detail. Thus, the present disclosure is not intended to be limited to the embodiments shown but is to be accorded the broadest scope consistent with the principles and features disclosed herein.

## Claims

1. A control method for controlling moving parts in a semiconductor process device, the semiconductor process device including a plurality of moving parts, the control method comprising:
obtaining a current process task, the process task including a plurality of sub-task objects;
determining a current sub-task object and sub-task objects that need to be executed from the plurality of sub-task objects, the sub-task objects that need to be executed are configured to be executed after the current sub-task object is executed;
controlling a current moving part associated with the current sub-task object to execute the current sub-task object;
after the execution of the current sub-task object is completed, determining standby moving parts associated with the sub-task objects that need to be executed; and
in response to the standby moving parts not including the current moving part, setting a movement state of the current moving part to ready.

2. The control method according to claim 1, before obtaining the current process task, further comprising:
receiving a plurality of process tasks and determining a first received process task to be the current process task;
identifying moving parts associated with each sub-task object in the current process task; and
setting the movement states of the moving parts associated with each sub-task object to occupied.

3. The control method according to claim 2, after determining the standby moving parts associated with the sub-task objects that need to be executed, further comprising:
in response to the standby moving parts including the current moving part, maintaining the movement state of the current moving part as occupied.

4. The control method according to claim 3, after setting the movement state of the current moving part to ready or maintaining the movement state of the current moving part as occupied, further comprising:
controlling the standby moving parts to sequentially execute the sub-task objects that need to be executed; and
after all sub-task objects in the current process task are executed, setting the movement state of each associated moving part to ready.

5. The control method according to claim 1, after setting the movement state of the current moving part to ready, further comprising:
determining whether process tasks to be executed after the current process task include the sub-task object associated with the current moving part; and
in response to the process tasks to be executed after the current process task including the sub-task object associated with the current moving part, controlling the current moving part to execute the sub-task object associated with the current moving part.

6. A control apparatus for controlling moving parts in a semiconductor process device, the semiconductor process device including a plurality of moving parts, the control apparatus comprising:
an acquisition unit configured to obtain a current process task, the process task including a plurality of sub-task objects;
a first determination unit configured to determine a current sub-task object and sub-task objects that need to be executed from the plurality of sub-task objects, the sub-task object that need to be executed being configured to be executed after the current sub-task object is executed;
a first control unit configured to control a current moving part associated with the current sub-task object to execute the current sub-task object;
a second determination unit configured to determine standby moving parts associated with the sub-task objects that need to be executed after the current sub-task object is executed; and
a first setting unit configured to set a movement state of the current moving part to ready when the standby moving parts do not include the current moving part.

7. The control apparatus according to claim 6, further comprising:
a receiving unit configured to receive a plurality of process tasks, and determine a process task received first as the current process task;
an identification unit configured to identify the moving parts associated with each sub-task object in the current process task; and
a second setting unit configured to set the movement states of the moving parts associated with each sub-task object to occupied.

8. The control apparatus according to claim 7, wherein the first setting unit is further configured to:
in response to the standby moving parts including the current moving part, maintain the movement state of the current moving part as occupied.

9. The control apparatus according to claim 8, further comprising:
a second control unit configured to control the standby moving parts to sequentially execute the sub-task objects that need to be executed; and
a third setting unit configured to set the movement state of each associated moving part to ready after all sub-task objects of the current process task are executed.

10. The control apparatus according to claim 6, further comprising:
a third determination unit configured to determine whether the process task to be executed after the current process task includes a sub-task object associated with the current moving part; and
a third control unit configured to control the current moving part to execute the sub-task object in advance when the process task to be executed after the current process task includes a sub-task object associated with the current moving part.

11. A semiconductor process device, comprising the control apparatus for controlling the plurality of moving parts in the semiconductor process device, according to any of claims 6-10.
